# EUROPÄISCHE PATENTANMELDUNG

(11) **EP 1 536 676 A2**
(43) Veröffentlichungstag der Anmeldung: **01.06.2005**
(21) Anmeldenummer: 04026337.8
(22) Anmeldetag: 05.11.2004
(51) Int. Cl.: H05K 7/20, G06F 1/20

(54) **Kühlvorrichtung zur Kühlung einer wärmeerzeugende Bauteile aufweisende elektrischen Komponente**

(30) Priorität: 28.11.2003 DE 10355598
(71) Anmelder: Fujitsu Siemens Computers GmbH, 80807 München (DE)
(72) Erfinder: Veh, Günther, 86856 Hiltenfingen (DE)
(74) Vertreter: Epping, Hermann, Fischer

(57) **Zusammenfassung**

Die vorliegende Erfindung betrifft Kühlvorrichtung, insbesondere zur Kühlung einer wärmeerzeugende Bauteile aufweisende elektrischen Komponente (1) eines Computersystems (2), mit einer Kühlanordnung (3), die mit der elektrischen Komponente (1) verbunden ist und einer in dem Computersystem (2) angeordneten Flüssigkeits-Kühlanordnung (7), zur Ableitung von Wärme durch Zirkulation von Flüssigkeit zu einem Wärmetauscher, wobei die Kühlanordnung (3) und die Flüssigkeits-Kühlanordnung (7) jeweils ein Wärmeleitrohr (5, 10) zur Übertragung von Wärmeenergie aufweisen und zwischen den Wärmeleitrohren (5, 10) eine thermisch leitfähige Verbindung hergestellt ist.

## Beschreibung

Die vorliegende Erfindung betrifft eine Kühlvorrichtung zur Kühlung einer wärmeerzeugende Bauteile aufweisenden elektrischen Komponente mit einer Kühlanordnung und einer Flüssigkeits-Kühlanordnung, zur Ableitung von Wärme durch Zirkulation von Flüssigkeit zu einem Wärmetauscher.

Mit zunehmender Arbeitsgeschwindigkeit von Computern wird von wärmeentwickelnden Bauteilen elektrischer Komponenten immer mehr Verlustwärme erzeugt. Wird diese Verlustwärme nicht zuverlässig von den elektrischen Komponenten abgeführt, indem für eine ausreichende Kühlung der wärmeentwickelnden Bauteile gesorgt wird, droht den Bauteilen eine thermische Überlastung mit der Folge von Fehlfunktionen oder völligem Ausfall.

Leistungsbauteile, wie beispielsweise Leistungsdioden, Leistungstransistoren oder Leistungsgleichrichter, werden daher in der Regel mit Kühlkörpern versehen, deren Kühlrippen über die natürliche Konvektion mit Luft für einen ausreichenden Wärmeaustausch sorgen. Zur Unterstützung einer zu erzielenden Kühlung werden Computersysteme daher im allgemeinen mit Lüftern versehen, die die im Computersystem erzeugte Verlustwärme nach außen ableiten.

Insbesondere eine Stromversorgung bzw. ein Netzteil des Computersystems, die bzw. das verschiedene elektronische Einrichtungen innerhalb des Computersystems mit Gleichstrom versorgt, benötigt eine zuverlässige und stabile Kühlanordnung, um einen zuverlässigen Betrieb des Computers sicherzustellen.

Um einen Ausfall des Computersystems während des Betriebs zu verhindern, ist konventionell auch jede Stromversorgung mit einem Lüfter versehen, der betrieben wird, um die Verlustwärme der Stromversorgung bzw. des Computersystems abzuführen.

Eine effektive Abführung der Verlustwärme läßt sich beispielsweise über weitere im Computer angeordnete Lüfter realisieren. Mit zunehmender Verlustwärme läßt sich jedoch ein zufriedenstellender Wirkungsgrad nicht mehr umsetzen. Zudem steigen mit der Anzahl der Lüfter die akustischen Geräusche und Gehäuseturbulenzen.

Flüssigkeits-Kühlanordnungen sind bekannt und führen erzeugte Verlustwärme durch Zirkulation von Kühlflüssigkeit zu einem beispielsweise im oder am Computergehäuse angeordneten Wärmetauscher. Hierdurch wird eine verbesserte Kühlwirkung und Minderung des Betriebsgeräusches erzielt. Im Kühlkreislauf der Flüssigkeits-Kühlanordnung sind in der Regel auch die auf den wärmeerzeugenden Bauteilen angeordneten Kühlkörper integriert. Beim Ausfall eines dieser Bauteile muß der Kühlkreislauf unterbrochen werden, da ein Austausch des Bauteils auch ein Entfernen und Austauschen des Kühlkörpers bedingt, so daß ein solcher Austausch einen nicht unerheblichen Aufwand bedeutet.

Es ist die Aufgabe der Erfindung, zum allgemeinen Stand der Technik zählende Kühlanordnungen dergestalt weiterzuentwickeln, daß eine hohe Wärmeabfuhr erzielt wird und eine einfacher Handhabung ermöglicht ist.

Diese Aufgabe wird durch eine Kühlvorrichtung, insbesondere zur Kühlung einer wärmeerzeugende Bauteile aufweisende elektrischen Komponente eines Computersystems gelöst, die eine Kühlanordnung, die auf der elektrischen Komponente angeordnet ist, und eine in dem Computersystem angeordnete Flüssigkeits-Kühlanordnung, zur Ableitung von Wärme durch Zirkulation von Flüssigkeit zu einem Wärmetauscher, aufweist, wobei die Kühlanordnung und die Flüssigkeits-Kühlanordnung jeweils ein Wärmeleitrohr zur Übertragung von Wärmeenergie aufweisen und zwischen den Wärmeleitrohren eine thermisch leitfähige Verbindung hergestellt ist.

Dabei wird vorteilhaft die Kühlanordnung der elektrischen Komponente an die Flüssigkeits-Kühlanordnung gekoppelt, so daß eine wesentlich effektivere Wärmeabfuhr der in der elektrischen Komponente erzeugten Verlustwärme erfolgen kann.

Zur Herstellung der thermisch leitfähigen Verbindung weisen die einander zugewandten Enden der Wärmeleitrohre flächig ausgebildete Kontakte auf. Wird die die Kühlanordnung aufweisende elektrische Komponente in das Computersystem eingebaut, berühren sich die Flächen der Kontakte der Wärmeleitrohre, so daß die Kühlkreisläufe thermisch miteinander verbunden werden und über die thermisch leitfähige Verbindung ein Austausch und Übergang der Wärmeenergie erfolgen kann.

Um die Kühlleistung vorteilhaft zu verbessern, können die Flächen beispielsweise trapezförmig ausgestaltet sein, so daß eine größere Fläche zur Bildung der thermischen Verbindung erzielt wird. Eine Erhöhung der Wärmeleitfähigkeit und eine Verbesserung einer mechanischen Gleitfunktion kann dadurch erzielt werden, daß die Flächen der Kontakte mit einer Wärmeleitpaste versehen sind. Wird weiterhin zumindest eine der Flächen mit einer Schutzschicht, beispielsweise aus Chrom, versehen, kann ein mechanischer Abrieb eingeschränkt werden.

Das Wärmeleitrohr der Flüssigkeits-Kühlanordnung ist mit einem Kühlkopf der Flüssigkeits-Kühlanordnung verbunden. Der Kühlkopf kontaktiert ein Federelement, welches beim Einbau der elektrischen Komponente in das Computersystem durch die Berührung der Kontakte der Wärmeleitrohre zusammengedrückt wird und eine formschlüssige Verbindung der flächig ausgebildeten Kontakte sicherstellt. Ohne daß eine mechanische Verbindung der einzelnen Kühlkreisläufe erfolgen muß, sind diese thermisch miteinander verbunden und ermöglichen einen thermischen Wärmeübergang.

Weitere Einzelheiten und Ausgestaltungen der Erfindung sind in den Unteransprüchen angegeben.

Im folgenden wird die Erfindung anhand der Figur näher erläutert.

Es zeigt:

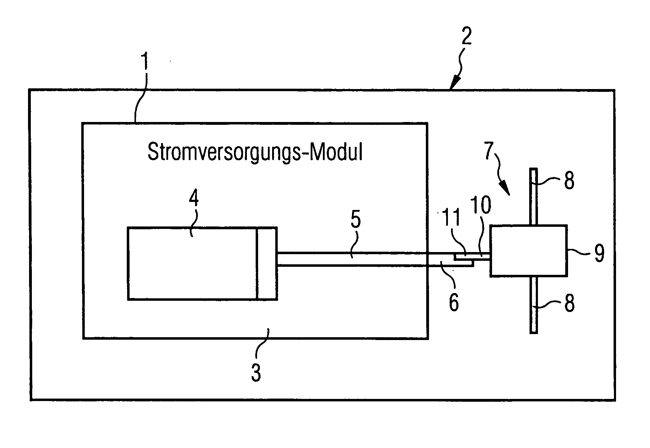

- Figur 1: eine schematische Darstellung einer erfindungsgemäßen Kühlvorrichtung.

In der Figur 1 ist eine erfindungsgemäße Kühlvorrichtung schematisch dargestellt. Eine elektronische Komponente 1 eines Computersystems 2, hier ein Stromversorgungs-Modul, weist zumindest ein, hier nicht dargestelltes, elektrisches Bauteil auf, welches im Betrieb der elektronischen Komponente 1 Verlustwärme erzeugt. Zur Ableitung der erzeugten Verlustwärme ist das Bauteil mit einer auf dem Bauteil angeordneten Kühlanordnung 3, in diesem Ausführungsbeispiel mit einem Kühlkörper 4 mit einem am Kühlkörper 4 angeordneten Wärmeleitrohr 5, versehen. Das Wärmeleitrohr 5 erstreckt sich in diesem Ausführungsbeispiel in seiner Länge über die Abmaße der elektrischen Komponente 1 hinaus. Die vorgeschlagene Kühlvorrichtung ist jedoch auch mit einem innerhalb der Abmaße der elektrischen Komponente 1 angeordneten Wärmeleitrohr 5 realisierbar. Das Wärmeleitrohr 5 der Kühlanordnung 3 weist an einem dem Kühlkörper 4 abgewandten Ende einen flächig ausgebildeten Kontakt 6 auf.

Eine in dem Computersystem 2 integrierte Flüssigkeits-Kühlanordnung 7 weist eine Kühlflüssigkeit führende Kühlleitungen 8 auf. Durch Zirkulation von Kühlflüssigkeit in diesem Kühlkreislauf zu einem in dem Computersystem 2 angeordneten, jedoch hier nicht sichtbaren Wärmetauscher wird erzeugte Verlustwärme abgeführt, indem im Wärmetauscher die erwärmte Kühlflüssigkeit über die Kühlleitungen 8 durch Lamellen des Wärmetauschers geführt wird und durch freie Konvektion an der Umgebungsluft abkühlt. Mit dem Kühlkreislauf über die Kühlleitungen 8 verbunden und somit im Kühlkreislauf integriert ist ein beweglich gelagerter Kühlkopf 9, mit dem ein Wärmeleitrohr 10 der Flüssigkeits-Kühlanordnung 7 verbunden ist. Das Wärmeleitrohr 10 der Flüssigkeits-Kühlanordnung 7 weist an der dem Kühlkopf 9 abgewandten Seite des Wärmerohrs 10 ebenfalls einen flächig ausgebildeten Kontakt 11 auf.

Beim Einbau der die Kühlanordnung 3 aufweisende elektrischen Komponente 1 in das Computersystem 2 schieben sich die flächig ausgebildeten Kontakte 6, 11 der Wärmeleitrohre 5, 10 übereinander und berühren sich, so daß eine thermisch leitfähige Verbindung hergestellt ist, die die Kühlanordnung 3 mit der Flüssigkeits-Kühlanordnung 7 koppelt. Zur Herstellung einer formschlüssigen Verbindung kontaktiert der Kühlkopf 9 ein hier nicht gezeigtes Federelement, welches bei der Berührung der Kontakte 6, 11 gespannt wird. Beim Ausbau der elektrischen Komponente 1 wird die thermisch leitende Verbindung unterbrochen, die Feder entspannt, wobei sich der Kühlkopf 9 in seine ursprüngliche Position bewegt.

Die vorgeschlagene Kühlvorrichtung erlaubt die Kopplung von Kühlkreisläufen ohne die Ausführung mechanischer Montagearbeiten, da zum Ein- und Ausbau der elektrischen Komponenten keine Unterbrechung der Kühlkreisläufe vorgenommen werden muß. Die Kühlvorrichtung kann so ausgelegt sein, daß eine Vielzahl von in einem Computersystem integrierte und eine Kühlanordnung aufweisende Komponenten an die im Computersystem integrierte Flüssigkeits-Kühlanordnung anschließbar sind. Somit sind Komponenten, beispielsweise eine Stromversorgung, die bisher im laufenden Betrieb austauschbar waren, auch weiterhin im laufenden Betrieb austauschbar, so daß seitens eines Endbenutzers oder eines Mitarbeiters eines Kundendienstes keine zusätzliche Handhabung beim Ein- und Ausbau dieser Komponenten erforderlich ist. Die Herstellung der thermisch leitenden Verbindung ist nicht auf die in diesem Ausführungsbeispiel aufgeführte Ausführung der Kontakte beschränkt. Vielmehr kann eine beliebige einem Fachmann geläufige Ausführung der Kontakte vorgenommen werden, bei der die Flächen der Kontakte formschlüssig verbindbar sind.

### Bezugszeichenliste

- 1: Elektrische Komponente
- 2: Computersystem
- 3: Kühlanordnung
- 4: Kühlkörper
- 5: Wärmeleitrohr
- 6: Kontakt
- 7: Flüssigkeits-Kühlanordnung
- 8: Kühlleitung
- 9: Kühlkopf
- 10: Wärmeleitrohr
- 11: Kontakt

## Patentansprüche

1. Kühlvorrichtung, insbesondere zur Kühlung einer wärmeerzeugende Bauteile aufweisende elektrischen Komponente (1) eines Computersystems (2), mit
- einer Kühlanordnung (3), die mit der elektrischen Komponente (1) verbunden ist und
- einer in dem Computersystem (2) angeordneten Flüssigkeits-Kühlanordnung (7), zur Ableitung von Wärme durch Zirkulation von Flüssigkeit zu einem Wärmetauscher,
**dadurch gekennzeichnet, daß**
die Kühlanordnung (3) und die Flüssigkeits-Kühlanordnung (7) jeweils ein Wärmeleitrohr (5, 10) zur Übertragung von Wärmeenergie aufweisen und zwischen den Wärmeleitrohren (5, 10) eine thermisch leitfähige Verbindung hergestellt ist.

2. Kühlvorrichtung (1) nach Anspruch 1,
**dadurch gekennzeichnet, daß**
die Wärmeleitrohre (5, 10) an ihren Enden flächig ausgebildete Kontakte (6, 11) aufweisen, wobei sich die Flächen der Kontakte (6,11) zur Herstellung der thermisch leitenden Verbindung berühren.

3. Kühlvorrichtung (1) nach Anspruch 2,
**dadurch gekennzeichnet, daß**
die Flächen der Kontakte (6, 11) trapezförmig ausgebildet sind.

4. Kühlvorrichtung(1) nach Anspruch 2 oder 3,
**dadurch gekennzeichnet, daß**
das Wärmeleitrohr (10) der Flüssigkeits-Kühlanordnung (7) mit einem beweglich gelagerten Kühlkopf (9) verbunden ist und an dem Kühlkopf (9) ein Federelement angeordnet ist, welches beim Einbau der elektrischen Komponente (1) in das Computersystem (2) zusammengedrückt wird, so daß die flächig ausgebildeten Kontakte (6, 11) der Wärmeleitrohre (5, 10) formschlüssig verbunden sind.

5. Kühlvorrichtung(1) nach Anspruch 1,
**dadurch gekennzeichnet, daß**
die Kühlanordnung (3) einen Kühlkörper (4) aufweist, mit dem das Wärmeleitrohr (5) der Kühlanordnung (3) verbunden ist, wobei der Kühlkörper (4) auf der elektrischen Komponente (1) und/oder auf dem wärmeerzeugenden Bauteil angeordnet ist.

6. Kühlvorrichtung(1) nach Anspruch 5,
**dadurch gekennzeichnet, daß**
durch den Kühlkörper (4) und das Wärmerohr (5) eine Kühlflüssigkeit zirkuliert.

7. Kühlvorrichtung (1) nach Anspruch 1,
**dadurch gekennzeichnet, daß**
die Kühlanordnung (3) einen geschlossenen Kreislauf eines Kühlsystems bildet.

8. Kühlvorrichtung (1) nach Anspruch 1,
**dadurch gekennzeichnet, daß**
die Flüssigkeits-Kühlanordnung (7) einen geschlossenen Kreislauf eines Kühlsystems außerhalb der elektrischen Komponente (1) innerhalb des Computersystems (2) bildet.

9. Kühlvorrichtung (1) nach Anspruch 1,
**dadurch gekennzeichnet, daß**
die thermisch leitfähige Verbindung der Wärmeleitrohre (5, 10) eine Übertragung der Wärmeenergie des Kühlkreislaufs der Kühlanordnung (3) in den Kühlkreislauf der Flüssigkeits-Kühlanordnung (7) vornimmt.

10. Kühlvorrichtung (1) nach Anspruch 1,
**dadurch gekennzeichnet, daß**
die thermisch leitfähige Verbindung ohne Unterbrechung der Kühlkreisläufe der Kühlanordnung (3) bzw. der Flüssigkeits-Kühlanordnung (7) lösbar ist.

11. Kühlvorrichtung (1) nach Anspruch 1,
**dadurch gekennzeichnet, daß**
die elektrische Komponente (1) eine Stromversorgung des Computersystems (2) ist.

12. Kühlvorrichtung (1) nach Anspruch 3,
**dadurch gekennzeichnet, daß**
die Flächen der Kontakte (6, 11) zur Erhöhung der Wärmeleitfähigkeit und Verbesserung einer mechanischen Gleitfunktion mit einer Wärmeleitpaste versehen sind.

13. Kühlvorrichtung (1) nach Anspruch 3,
**dadurch gekennzeichnet, daß**
zumindest eine der Flächen der Kontakte (6, 11) mit einer Schutzschicht versehen ist, die einen Schutz vor mechanischem Abrieb gewährleistet.
